# EUROPEAN PATENT SPECIFICATION

(11) **EP 3 336 990 B1**
(45) Date of publication and mention of the grant of the patent: **16.06.2021**
(21) Application number: 16205020.7
(22) Date of filing: 19.12.2016
(51) Int. Cl.: H02G 5/00, H05K 1/02, H05K 3/46

(54) **LAMINATED MULTI-PHASE BUSBAR AND METHOD OF MANUFACTURING THE SAME**
LAMINIERTE MEHRPHASIGE SAMMELSCHIENE UND VERFAHREN ZUR HERSTELLUNG DAVON
BARRE OMNIBUS MULTIPHASE LAMINÉE ET SON PROCÉDÉ DE FABRICATION

(43) Date of publication of application: 20.06.2018
(73) Proprietor: ABB Schweiz AG, 5400 Baden (CH)
(72) Inventor: Velthuis, Rudi, 79787 Lauchringen (DE); Meier, Guido, 5303 Würenlingen (CH)
(74) Representative: Maiwald Patent- und Rechtsanwaltsgesellschaft mbH

(56) References cited:
- WO-A1-84/01861
- WO-A2-2012/135673
- DE-B4-102005 015 945
- US-A- 3 663 866
- US-A- 3 893 233
- US-A1- 2001 025 718
- US-A1- 2014 212 624
- US-B1- 6 329 603

## Description

The invention is related to a laminated multi-phase busbar and a method of manufacturing the same according to the preamble of claims 1 and 6.

Multi-phase busbars are used in switchboards and/or in switchgears, in particular low voltage switchgears, to conduct and distribute alternating electrical current to different electrical devices that are usually installed in switch gear cabinets. In order to provide for the possibility to conduct all three phases or even more phases of an alternating current in a single busbar, multi-phase busbars have been developed which comprise a base layer and a cover layer of electrically insulating material between which two or more layers of conducting sheet metal, in particular copper, are arranged that are electrically insulated from each other by means of insulating intermediate layers.

The afore-described laminated busbars are described in DE 10 2005 015 945 B4 of the applicant and have the advantage that they are compact and do not tend to delaminate due to forces generated by eddy currents which are induced by the alternating electric currents that are conducted in the different conducting layers for each phase. A further advantage can be seen in that electrical losses in the busbar system as well as the forces generated by eddy currents are reduced or even locally cancelled due to the phase shifts of the electrical current flow in each of the conducting layers.

US 3 663 866 A describes a back plane composed of a laminate structure formed by multiple layers of conductive sheets separated by intervening layers of insulation. In one form the back plane is composed of sheets of copper. The insulation is an Epoxy non-woven glass material.

US 2001/025718 A1 describes a bus bar wiring plate body for an electric coupling box. The bus bar members are wired between pre-hardening epoxy resin plates subjected to a heat pressing process to thereby integrate the pre-hardening epoxy resin plates and the bus bar members in a laminated state.

WO 2012/135673 A2 describes a method for manufacturing a multilayer bus bar apparatus including mapping a thin film dielectric insulating material around selected surfaces of conductive members, placing the combined assembly in a heated press, heating the combined assembly and applying pressure to plate to bond the insulating layers.

US 6 329 603 B1 describes metallized, low CTE power and ground planes that are laminated with other planes into a composite, or laminated into a core which is then laminated with other planes into a composite.

US 3 898 233 A describes a bus bar of laminar construction for power distribution systems. The bus bar comprises a plurality of metallic conductors in sheet form separated by insulator films in a laminated structure, alternate conductor sheets serving as ground planes with the power signal conductors interleaved between the ground conductors.

WO 84/01861 A1 describes a bus bar assembly with a plurality of flat, elongated conductors in stacked alignment, and with insulating washers acting as spacers there between.

US 2014/0212624 A1 describes a fiber-reinforced member, where a mold clamping enables insert members to be clamped between upper and lower fiber-reinforced resin sheets, be plastically deformed, be pushed outward in the radial direction, and spread to the interior of an opening of a plate material.

One problem of the busbars as described in DE 10 2005 015 945 B4 are the costs involved in the lamination process itself, in which the different layers are bond to each other by means of liquid resin, e.g. epoxy resin. As the resins used for the laminating process usually require specific safety precautions for the staff involved in the production process, the production costs are high.

This problem is solved by a laminated multi-phase busbar as claimed in claim 1 and a method of manufacturing the same as claimed in claim 6.

Further objects of the present invention are included in the dependent claims.

According to the invention, a laminated multi-phase busbar for conducting electric energy comprises a base layer of an electrically insulating material, a first conducting layer of an electrically conducting material which is arranged on and mechanically connected to said base layer, a first intermediate insulating layer of an electrically insulating material which is arranged on and mechanically connected to said first conducting layer, a second conducting layer of an electrically conducting material which is arranged on and mechanically connected to said first intermediate layer and a cover layer of an electrically insulating material which is arranged on and mechanically connected to said second conducting layer. The busbar 1 is characterized in that the electrically insulating material of said base layer, said first intermediate layer and said cover layer is a sheet molding compound including a thermosetting resin and reinforcing fibers, and that the material of said first conducting layer and said second conducting layer is a sheet metal, preferably copper, which is mechanically bonded to the intermediate insulating layer by said thermally cured thermosetting resin. Further technical features are disclosed in claim 1.

According to a further aspect of the invention, the method of manufacturing a multi-phase busbar is characterized by the following method steps:
- forming a stack including at least
   a) a base layer of an uncured sheet molding compound,
   b) a first conducting layer of a sheet metal
   c) an intermediate layer of an uncured sheet molding compound,
   d) a second conducting layer of a sheet metal and
   e) a cover layer of an uncured sheet molding compound,
   wherein said sheet molding compound includes a partially cured thermosetting resin and reinforcing fibers which are movable within said resin,
- providing at least one first pin hole in said stack, said first pin hole extending from said cover layer to said first conducting layer and arranging a first conducting pin contacting said first conducting layer inside said first pin hole,
- providing at least one second pin hole in said stack, said second pin hole extending from said cover layer to said second conducting layer and arranging a second conducting pin contacting said second conducting layer inside said second pin hole,
- placing said stack inside a heated mold of a press, closing said mold and applying pressure to said press for a predetermined period of time, said pressure having a level which enables the resin and the fibers of said sheet molding component to flow into said first and second pin holes, and
- opening said mold and removing said cured stack from said mold.

The invention provides for the advantage that by using SMC material, which has been on the market for nearly 50 years by now, the production costs of the laminated busbar can be significantly reduced.

As the applicant of the present invention has found, the bonding of the SMC material to the metal/copper layers is sufficient to take up the strong magnetic forces which are generated by the electric currents flowing through the conducting layers of the busbar without delaminating the layers. These currents may in case of an electrical short circuit easily reach a magnitude of several thousand Amperes.

The invention is hereinafter described with reference to the accompanying drawings. In the drawings
- Fig. 1: shows a schematic top view of the multi-phase busbar according to the present invention after positioning the stack of uncured layers in a cavity of a schematically indicated mold of a heat molding press,
- Fig. 2: is a schematic side view of the busbar according to the present invention during the production process right after placing the stack of layers in a heated mold and applying pressure to the stack, and
- Fig. 3: is a schematic cross-sectional view of the busbar of Fig. 2 after curing of the sheet molding compound.

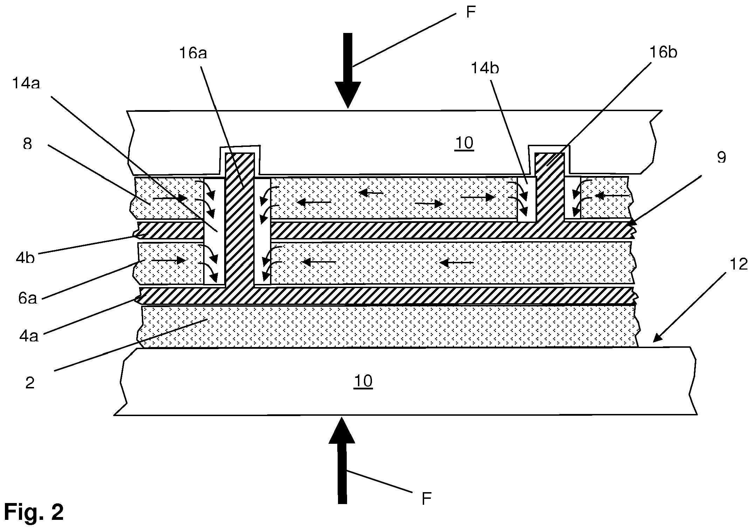

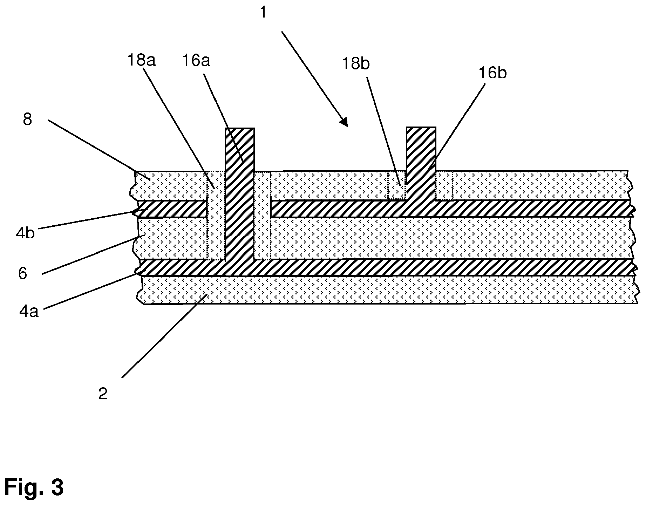

As can be seen best from Figs. 2 and 3, a laminated multi-phase busbar 1 for conducting electric energy comprises a base layer 2 of an electrically insulating material, a first conducting layer 4a of an electrically conducting material which is arranged on said base layer 2. The busbar 1 further comprises a first intermediate insulating layer 6 of an electrically insulating material which is arranged on the first conducting layer 4a, a second conducting layer 4b which is arranged on said first intermediate layer 6 and a cover layer 8. The busbar 1 shown in Figs. 2 and 3 represents a basic configuration of a busbar which is designed to conduct e.g. only one electrical phase and neutral or two electrical phases. For conducting two or even more electrical phases of an electric alternating current, there may be arranged one or more further conducting layers 4 and intermediate layers 6 in between the cover layer 8 and the second conducting layer 4b, which are not shown for reasons of simplification, so that a busbar 1 for conducting three phases and zero may comprise four conducting layers 4 and four intermediate layers 6 in total.

According to the invention, the electrically insulating material of the base layer 2, the cover layer 8 and the intermediate layers 6 is a sheet molding compound which includes a thermosetting resin and reinforcing fibers, e.g. cut glass fibers, having a length of 0, 5 mm to 5 mm. The resin used for such known SMC-material may be a polyester resin or epoxy resin which is partially cured and which includes a curing agent that can be activated by the application of heat. Such SMC-material is a known construction material for housing and casings and the like which is commonly available on the market.

As it can further be seen from Fig. 2 and 3, a first conducting pin 16a for electrically connecting the first conducting layer 4a to an electric energy source (not shown) is mechanically attached or glued to or alternatively integrally formed with the first conducting layer 4a. In the same way, a second conducting pin 16b is mechanically connected to or integrally formed with the second conducting layer 4b. The first conducting pin 16a and second conducting pin 16b extend parallel to each other in a direction which is preferably perpendicular to the different layers 2, 4a, 6, 4b and 8 which are arranged in a stack 9.

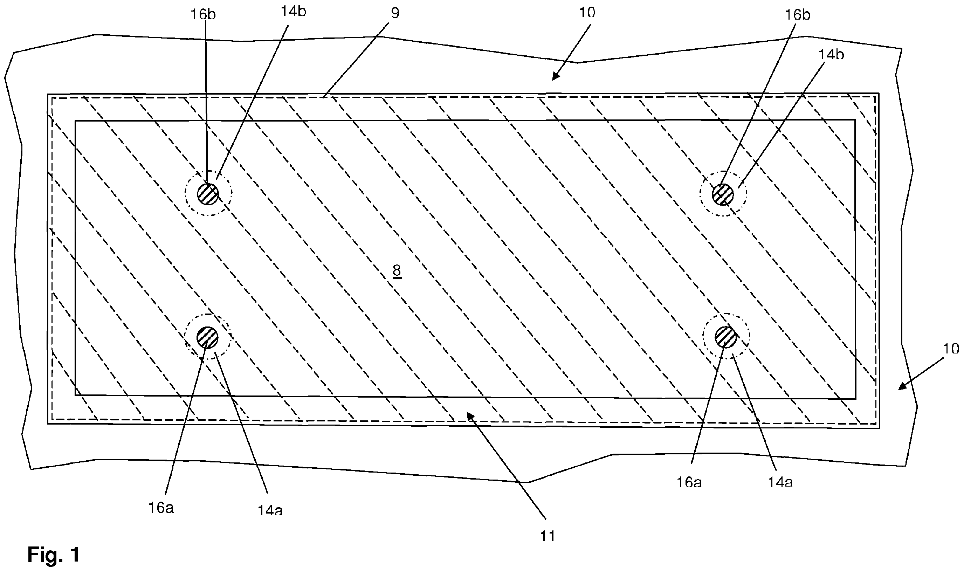

As can be seen in Fig. 1 and in more detail in Fig. 2, the cover layer 8, the second conducting layer 4b and the intermediate layer 6 comprise openings which in the stack 9 form a first pin hole 14a around the first conducting pin 16a. In the same way, the cover layer 8 comprises a further opening which is positioned around the second conducting pin 16b when placing the stack 9 of layers in a cavity 12 of a heated mold 10 of a sheet molding press, as it is schematically indicated in Fig. 1.

In the stack 9 of layers, the first pin holes 14a in the intermediate layer 6, the second conducting layer 4b and the cover layer 8 have a larger diameter than the diameter of the first conducting pin 16a and are aligned along the central longitudinal axis of the conducting pin 16a, in order to form a recess into which the liquefied thermosetting resin of the insulating layer 6 and cover layer 8 can flow when applying a force F to the stack 9 after positioning it in the heated mold 10 (Fig. 2). In the same way, the second pin hole 14b comprises a larger diameter than the second conducting pin 16b, in order to allow the liquefied thermosetting resin and the fibers included therein to flow into the second pin hole 14b during the compression molding process.

The method of manufacturing an afore-described busbar with 2 conducting layers 4a and 4b according to a further aspect of the present invention will now be described with reference to Fig. 1 to 3.

Firstly, the copper/sheet metal of the conducting layers 4a, 4b is preferably pretreated, in particular etched with a known acid or sand blasted, in order to enable a good bonding with the resin. Then the different layers which have preferably been cut to the desired shape and size before, are arranged above each other in a stack 9 and the entire stack 9 of materials is placed in the cavity 12 of a heated mold 10 of a compression molding press and the mold 10 is closed as indicated by the dashed lines in Fig. 1.

The heat of the mold 10 in combination with the pressure, which may be in the range of several thousand MPa, reduces the viscosity of the initially semi-rigid resin and causes the resin and the fibers included therein to flow into the pin holes 14a and 14b and other openings and recesses (not shown) which may be formed in the conducting layers and insulating layers. Moreover, the liquefied resin and fibers also flow into the space 11 which is arranged around the outer edges of the layers/stack 9 and the inner wall of the mold 10 which define the cavity 12, thereby forming a layer of insulating material on the outside of the stack 9 which advantageously electrically insulates the outer edges of the conducting layers 4a, 4b without employing additional steps. In other words, the copper layers 4a, 4b are now completely encapsulated by the resin of the SMC material, whereby the high
pressure not only presses the material into any openings and cavities in the conducting material, but also reduces the size of any voids which may be initially included in the original SMC-layers.

The distance between the copper layers 4a, 4b is provided by the fact that the SMC-layers 2, 6 and 8 are preferably cut in such a way that little material flow can take place. Before the compression molding is started, preferably 90 % of the mold 10 is covered with SMC, the remaining 10 % is filled after the compression.

To do so, the mold 10 for receiving the stack of layers 2, 4a, 4b, 6, 8 preferably comprises a cubical cavity 12 which has a first cross section when viewed in the direction of the conducting pins 16a, 16b (Fig. 1). The layers 2, 4a, 4b, 6, 8 included in the stack 9 comprise a second cross section which has a surface area that covers between 80% and 95%, preferably 90% of the area of the first cross section. By lowering the dye of the sheet molding press (which is indicated in Fig. 1 in dashed lines) into the mold cavity 12, the viscosity of the partially cured SMC-material of the base layer 2, cover layer 8 and the insulating layer(s) 6 is reduced and the resin and fibers flow into the space 11 until it is entirely filled up with resin.

After a predetermined period of time, e.g. 8 to 10 min, the mold is opened and the hot cured stack 9 of layers is removed from the press cavity 12, in order to allow the stack 9 to cool down. After the stack 9 has cooled down to room temperature and the resin has cured completely, the conducting pins 16a, 16b may be cleaned, and the terminals or shipping splits may be deflashed if necessary. As can be seen from Fig. 3, the conducting pins 16a, 16b are mechanically bonded to the insulating layers 6 and to the cover layer 8 by material bridges 18a, 18b of cured resin and fibers which also contribute to hold the stack 9 together in case of the occurrence of delaminating forces which act upon the conducting layers 4a, 4b when short circuiting the conducting layers 4a, 4b .

In order to ease the removal of the hot stack 9 from the mold 10, the base layer 2 and/or the cover layer 8 may include an internal release agent which prevents the base layer 2 and/or the cover layer 8 from adhering to heated parts of the mold 10.

### Listing of reference signs

- 1: busbar
- 2: base layer
- 4a: first conducting layer
- 4b: second conducting layer
- 6: first intermediate layer
- 8: cover layer
- 9: stack/sandwich of layers
- 10: heated mold of sheet molding press
- 11: space between inner wall of cavity and stack
- 12: cavity of mold
- 14a: first pin hole
- 14b: second pin hole
- 16a: first conducting pin
- 16b: second conducting pin
- 18a: material bridge around first conducting pins
- 18b: material bridge around second conducting pins
- F: compressive force

## Claims

1. Laminated multi-phase busbar (1) for conducting electric energy, comprising a base layer (2) of an electrically insulating material, a first conducting layer (4a) of an electrically conducting material which is arranged on and mechanically connected to said base layer (2), a first intermediate insulating layer (6) of an electrically insulating material which is arranged on and mechanically connected to said first conducting layer (4a), a second conducting layer (4b) of an electrically conducting material which is arranged on and mechanically connected to said first intermediate layer (6) and a cover layer (8) of an electrically insulating material which is arranged on and mechanically connected to said second conducting layer (4b),
wherein at least one first pin hole (14a) is formed in said intermediate insulating layer (6), said second conducting layer (4b) and said cover layer (8), and that a first conducting pin (16a) for conducting electric energy to said first conducting layer (4a) is arranged inside said first pin hole (14a), said first conducting pin (16a) being electrically connected to said first conducting layer (4a) and having a smaller diameter than said first pin hole (14a) in said second conducting layer (4b),
wherein the material of said first conducting layer (4a) and said second conducting layer (4b) is a sheet metal which is mechanically connected to the intermediate insulating layer by a thermally cured thermosetting resin
**characterized in that** the electrically insulating material of said base layer (2), said first intermediate layer (6) and said cover layer (8) is a sheet molding compound including a thermosetting resin and reinforcing fibers, and
that said first conducting pin (16a) is mechanically bonded to the intermediate insulating layer (6) and to the cover layer (8) by a material bridge (18a) of cured resin and fibers of said sheet molding compound of said first intermediate insulating layer (6) and said insulating cover layer (8).

2. Laminated multi-phase busbar according to claim 1,
**characterized in that** the sheet molding compound includes a thermally curable polyester or epoxy resin and/or chopped glass fibers.

3. Laminated multi-phase busbar according to any of the previous claims,
**characterized in that** the base layer (2) comprises a release agent which reduces the bonding forces between the thermally cured thermosetting resin of said base layer (2) and said sheet metal of said first electrically conducting layer (4a), and/or that the cover layer comprises a release agent which reduces the bonding forces between the thermally cured thermosetting resin of said cover layer (8) and said sheet metal of said second electrically conducting layer (4b), and that said intermediate insulating layer (6) includes no internal release agent.

4. Laminated multi-phase busbar according to any of the previous claims,
**characterized in that** at least one second pin hole (14b) is formed in said cover layer (8), and that a second conducting pin (16b) for conducting electric energy to said second conducting layer (4b) is arranged inside said second pin hole (14b), said second conducting pin (16b) being electrically connected to said second conducting layer (4b) and having a smaller diameter than said second pin hole (14b).

5. Laminated multi-phase busbar according to any of the previous claims,
**characterized in that** at least one further electrically conducting layer (4) and a further intermediate insulating layer (6) of a sheet molding compound are arranged in between said cover layer (8) and said second conducting layer (4b) for conducting a further electrical phase of said electric energy.

6. Method of manufacturing a multi-phase busbar according to any of the preceding claims **characterized by** the following method steps:
- forming a stack including at least
**a)** a base layer (2) of an uncured sheet molding compound,
**b)** a first conducting layer (4a) of a sheet metal
**c)** an intermediate layer (6) of an uncured sheet molding compound,
**d)** a second conducting layer (4b) of a sheet metal and
**e)** a cover layer (8) of an uncured sheet molding compound,
wherein said sheet molding compound includes a partially cured thermosetting resin and reinforcing fibers which are movable within said resin, said first conducting pin (16a) having a smaller diameter than said first pin hole (14a),
- providing at least one first pin hole (14a) in said stack, said first pin hole (14a) extending from said cover layer to said first conducting layer and arranging a first conducting pin (16a) contacting said first conducting layer (4a) inside said first pin hole (14a),
- providing at least one second pin hole (14b) in said stack, said second pin hole (14b) extending from said cover layer (4a) to said second conducting layer (4b) and arranging a second conducting pin (16b) contacting said second conducting layer (4b) inside said second pin hole (14b),
- placing said stack inside a heated mold (10) of a press, closing said mold (10) and applying pressure to said press for a predetermined period of time, said pressure having a level which enables the resin and the fibers of said sheet molding component to flow into said first and second pin holes (14a, 14b), and
- opening said mold (10) and removing said cured stack from said mold (10).

7. Method of claim 6,
**characterized in that** the mold (10) for receiving the stack of layers (2, 4a, 4b, 6, 8) comprises a cubical cavity having a first cross section when viewed in the direction of the conducting pins (16a, 16b), and that the layers included in the stack (2, 4a, 4b, 6, 8) comprise a second cross section having a surface area which covers between 80% and 95%, preferably 90% of the area of the first cross section.

8. Method of claim 6 or 7,
**characterized in that** said first and the second conducting layers (4a, 4b) are formed of copper, and that said copper is pretreated, in particular etched and/or sand blasted, before arranging said sheet metal between said layers (2, 6 and 8) of uncured sheet molding compound.

9. Method according to claim 7or 8,
**characterized in that** the base layer (2) and/or the cover layer (8) include an internal release agent which prevents the
base layer (2) and/or the cover layer (8) from adhering to adhering to heated parts of the mold (10).

## Patentansprüche

1. Laminierte Mehrphasen-Sammelschiene (1) zum Leiten elektrischer Energie, mit einer Basisschicht (2) aus einem elektrisch isolierenden Material, einer ersten leitenden Schicht (4a) aus einem elektrisch leitenden Material, die auf der Basisschicht (2) angeordnet und mit dieser mechanisch verbunden ist, einer ersten isolierenden Zwischenschicht (6) aus einem elektrisch isolierenden Material, die auf der ersten leitenden Schicht (4a) angeordnet und mit dieser mechanisch verbunden ist, eine zweite leitende Schicht (4b) aus einem elektrisch leitenden Material, die auf der ersten Zwischenschicht (6) angeordnet und mechanisch mit dieser verbunden ist, und eine Deckschicht (8) aus einem elektrisch isolierenden Material, die auf der zweiten leitenden Schicht (4b) angeordnet und mechanisch mit dieser verbunden ist,
wobei mindestens ein erstes Stiftloch (14a) in der isolierenden Zwischenschicht (6), der zweiten leitenden Schicht (4b) und der Deckschicht (8) ausgebildet ist, und dass ein erster leitender Stift (16a) zum Leiten elektrischer Energie zu der ersten leitenden Schicht (4a) innerhalb des ersten Stiftlochs (14a) angeordnet ist, wobei der erste leitende Stift (16a) elektrisch mit der ersten leitenden Schicht (4a) verbunden ist und einen kleineren Durchmesser als das erste Stiftloch (14a) in der zweiten leitenden Schicht (4b) hat,
wobei das Material der ersten leitenden Schicht (4a) und der zweiten leitenden Schicht (4b) ein Blech ist, das mechanisch mit der isolierenden Zwischenschicht durch ein thermisch gehärtetes wärmehärtendes Harz verbunden ist,
**dadurch gekennzeichnet, dass** das elektrisch isolierende Material der Basisschicht (2), der ersten Zwischenschicht (6) und der Deckschicht (8) eine Blechformmasse ist, die ein wärmehärtendes Harz und Verstärkungsfasern enthält, und dass der erste leitende Stift (16a) mechanisch mit der isolierenden Zwischenschicht (6) und der Deckschicht (8) durch eine Materialbrücke (18a) aus gehärtetem Harz und Fasern der Blechformmasse der ersten isolierenden Zwischenschicht (6) und der isolierenden Deckschicht (8) verbunden ist.

2. Laminierte Mehrphasen-Sammelschiene nach Anspruch 1, **dadurch gekennzeichnet, dass** die Blechformmasse ein thermisch härtbares Polyester- oder Epoxidharz und/oder geschnittene Glasfasern enthält.

3. Laminierte Mehrphasen-Sammelschiene nach einem der vorhergehenden Ansprüche, **dadurch gekennzeichnet, dass** die Basisschicht (2) ein Trennmittel enthält, das die Bindungskräfte zwischen dem thermisch gehärteten wärmehärtenden Harz der Basisschicht (2) und dem Blech der ersten elektrisch leitenden Schicht (4a) reduziert, und/oder dass die Deckschicht ein Trennmittel enthält, das die Bindungskräfte zwischen dem thermisch gehärteten wärmehärtenden Harz der Deckschicht (8) und dem Blech der zweiten elektrisch leitenden Schicht (4b) reduziert, und dass die isolierende Zwischenschicht (6) kein inneres Trennmittel enthält.

4. Laminierte Mehrphasen-Sammelschiene nach einem der vorhergehenden Ansprüche, **dadurch gekennzeichnet, dass** in der Deckschicht (8) mindestens ein zweites Stiftloch (14b) ausgebildet ist, und dass innerhalb des zweiten Stiftlochs (14b) ein zweiter Leitstift (16b) zum Leiten von elektrischer Energie zu der zweiten leitenden Schicht (4b) angeordnet ist, wobei der zweite Leitstift (16b) mit der zweiten leitenden Schicht (4b) elektrisch verbunden ist und einen kleineren Durchmesser als das zweite Stiftloch (14b) aufweist.

5. Laminierte Mehrphasen-Sammelschiene nach einem der vorhergehenden Ansprüche, **dadurch gekennzeichnet, dass** zwischen der Deckschicht (8) und der zweiten leitenden Schicht (4b) mindestens eine weitere elektrisch leitende Schicht (4) und eine weitere Zwischenisolierschicht (6) aus einer Blechformmasse zur Leitung einer weiteren elektrischen Phase der elektrischen Energie angeordnet sind.

6. Verfahren zur Herstellung einer mehrphasigen Stromschiene nach einem der vorhergehenden Ansprüche, **gekennzeichnet durch** die folgenden Verfahrensschritte:
- Bilden eines Stapels mit mindestens
a) eine Basisschicht (2) aus einer unausgehärteten Blechformmasse
b) eine erste leitende Schicht (4a) aus einem Metallblech
c) eine Zwischenschicht (6) aus einer unausgehärteten Blechformmasse
d) eine zweite leitende Schicht (4b) aus einem Blech und
e) eine Deckschicht (8) aus einer unausgehärteten Blechformmasse,
wobei die Blechformmasse ein teilweise gehärtetes wärmehärtendes Harz und Verstärkungsfasern enthält, die innerhalb des Harzes beweglich sind, wobei der erste leitende Stift (16a) einen kleineren Durchmesser als das erste Stiftloch (14a) hat,
- Bereitstellen mindestens eines ersten Stiftlochs (14a) in dem Stapel, wobei sich das erste Stiftloch (14a) von der Deckschicht zu der ersten leitenden Schicht erstreckt, und Anordnen eines ersten leitenden Stifts (16a), der die erste leitende Schicht (4a) innerhalb des ersten Stiftlochs (14a) kontaktiert,
- Bereitstellen mindestens eines zweiten Stiftlochs (14b) in dem Stapel, wobei sich das zweite Stiftloch (14b) von der Deckschicht (4a) zu der zweiten leitenden Schicht (4b) erstreckt, und Anordnen eines zweiten leitenden Stifts (16b), der die zweite leitende Schicht (4b) innerhalb des zweiten Stiftlochs (14b) kontaktiert,
- Anordnen des Stapels in einer beheizten Form (10) einer Presse, Schließen der Form (10) und Aufbringen von Druck auf die Presse für eine vorbestimmte Zeitdauer, wobei der Druck ein Niveau hat, das es dem Harz und den Fasern der Blattformkomponente ermöglicht, in das erste und zweite Stiftloch (14a, 14b) zu fließen, und
- Öffnen der Form (10) und Entfernen des gehärteten Stapels aus der Form (10).

7. Verfahren nach Anspruch 6, **dadurch gekennzeichnet, dass** die Form (10) zur Aufnahme des Stapels aus Schichten (2, 4a, 4b, 6, 8) einen kubischen Hohlraum aufweist, der in Richtung der Leiterstifte (16a, 16b) gesehen einen ersten Querschnitt aufweist, und dass die im Stapel enthaltenen Schichten (2, 4a, 4b, 6, 8) einen zweiten Querschnitt aufweisen, der eine Fläche hat, die zwischen 80 % und 95 %, vorzugsweise 90 %, der Fläche des ersten Querschnitts abdeckt.

8. Verfahren nach Anspruch 6 oder 7, **dadurch gekennzeichnet, dass** die erste und die zweite leitende Schicht (4a, 4b) aus Kupfer gebildet werden, und dass das Kupfer vor dem Anordnen des Blechs zwischen den Schichten (2, 6 und 8) aus unausgehärteter Blechformmasse vorbehandelt, insbesondere geätzt und/oder sandgestrahlt wird.

9. Verfahren nach Anspruch 7 oder 8, **dadurch gekennzeichnet, dass** die Basisschicht (2) und/oder die Deckschicht (8) ein internes Trennmittel enthalten, das ein Anhaften der Basisschicht (2) und/oder der Deckschicht (8) an erwärmten Teilen der Form (10) verhindert.

## Revendications

1. Barre de distribution polyphasée stratifiée (1) destinée à conduire l'énergie électrique, comprenant une couche de base (2) dans un matériau électriquement isolant, une première couche conductrice (4a) dans un matériau électriquement conducteur qui est disposée sur et liée mécaniquement à ladite couche de base (2), une première couche intermédiaire isolante (6) dans un matériau électriquement isolant qui est disposée sur et liée mécaniquement à ladite première couche conductrice (4a), une deuxième couche conductrice (4b) dans un matériau électriquement conducteur qui est disposée sur et liée mécaniquement à ladite première couche intermédiaire (6), et une couche de revêtement (8) dans un matériau électriquement isolant qui est disposée sur et liée mécaniquement à ladite deuxième couche conductrice (4b),
dans laquelle au moins un premier trou d'épingle (14a) est formé dans ladite couche intermédiaire isolante (6), ladite deuxième couche conductrice (4b) et ladite couche de revêtement (8), et une première broche conductrice (16a) destinée à conduire l'énergie électrique jusqu'à ladite première couche conductrice (4a) est disposée à l'intérieur dudit premier trou d'épingle (14a), ladite première broche conductrice (16a) étant reliée électriquement à ladite première couche conductrice (4a) et ayant un plus petit diamètre que ledit premier trou d'épingle (14a) dans ladite deuxième couche conductrice (4b),
dans laquelle le matériau de ladite première couche conductrice (4a) et de ladite deuxième couche conductrice (4b) est un métal en feuille qui est lié mécaniquement à la couche intermédiaire isolante par une résine thermodurcissable thermodurcie,
**caractérisée en ce que** le matériau électriquement isolant de ladite couche de base (2), de ladite première couche intermédiaire (6) et de ladite couche de revêtement (8) est un composé de moulage en feuille comportant une résine thermodurcissable et des fibres de renforcement, et
**en ce que** ladite première broche conductrice (16a) est assemblée mécaniquement à la couche intermédiaire isolante (6) et à la couche de revêtement (8) par un pont de matière (18a) de résine durcie et de fibres dudit composé de moulage en feuille de ladite première couche intermédiaire isolante (6) et de ladite couche de revêtement isolante (8).

2. Barre de distribution polyphasée stratifiée selon la revendication 1,
**caractérisée en ce que** le composé de moulage en feuille comporte une résine de polyester ou époxy thermodurcissable et/ou des fibres de verre coupées.

3. Barre de distribution polyphasée stratifiée selon l'une quelconque des revendications précédentes,
**caractérisée en ce que** la couche de base (2) comprend un agent antiadhésif qui réduit les forces de liaison entre la résine thermodurcissable thermodurcie de ladite couche de base (2) et ledit métal en feuille de ladite première couche électriquement conductrice (4a), et/ou **en ce que** la couche de revêtement comprend un agent antiadhésif qui réduit les forces de liaison entre la résine thermodurcissable thermodurcie de ladite couche de revêtement (8) et ledit métal en feuille de ladite deuxième couche électriquement conductrice (4b), et **en ce que** ladite couche intermédiaire isolante (6) ne comporte pas d'agent antiadhésif interne.

4. Barre de distribution polyphasée stratifiée selon l'une quelconque des revendications précédentes,
**caractérisée en ce qu'au** moins un deuxième trou d'épingle (14b) est formé dans ladite couche de revêtement (8), et **en ce qu'**une deuxième broche conductrice (16b) destinée à conduire l'énergie électrique jusqu'à ladite deuxième couche conductrice (4b) est disposée à l'intérieur dudit deuxième trou d'épingle (14b), ladite deuxième broche conductrice (16b) étant reliée électriquement à ladite deuxième couche conductrice (4b) et ayant un plus petit diamètre que ledit deuxième trou d'épingle (14b).

5. Barre de distribution polyphasée stratifiée selon l'une quelconque des revendications précédentes,
**caractérisée en ce qu'**au moins une autre couche électriquement conductrice (4) et une autre couche intermédiaire isolante (6) d'un composé de moulage en feuille sont disposées entre ladite couche de revêtement (8) et ladite deuxième couche conductrice (4b) pour conduire une autre phase électrique de ladite énergie électrique.

6. Procédé de fabrication d'une barre de distribution polyphasée selon l'une quelconque des revendications précédentes, **caractérisé par** les étapes de procédé suivantes :
- former un empilement comportant au moins
**a)** une couche de base (2) d'un composé de moulage en feuille non durci,
**b)** une première couche conductrice (4a) d'un métal en feuille,
**c)** une couche intermédiaire (6) d'un composé de moulage en feuille non durci,
**d)** une deuxième couche conductrice (4b) d'un métal en feuille, et
**e)** une couche de revêtement (8) d'un composé de moulage en feuille non durci,
ledit composé de moulage en feuille comportant une résine thermodurcissable partiellement durcie et des fibres de renforcement qui sont mobiles à l'intérieur de ladite résine, ladite première broche conductrice (16a) ayant un plus petit diamètre que ledit premier trou d'épingle (14a),
- ménager au moins un premier trou d'épingle (14a) dans ledit empilement, ledit premier trou d'épingle (14a) s'étendant de ladite couche de revêtement à ladite première couche conductrice et mettant une première broche conductrice (16a) en contact avec ladite première couche conductrice (4a) à l'intérieur dudit premier trou d'épingle (14a),
- ménager au moins un deuxième trou d'épingle (14b) dans ledit empilement, ledit deuxième trou d'épingle (14b) s'étendant de ladite couche de revêtement (4a) à ladite deuxième couche conductrice (4b) et mettant une deuxième broche conductrice (16b) en contact avec ladite deuxième couche conductrice (4b) à l'intérieur dudit deuxième trou d'épingle (14b),
- placer ledit empilement à l'intérieur d'un moule chauffé (10) d'une presse, fermer ledit moule (10) et appliquer une pression à ladite presse pendant un laps de temps prédéterminé, ladite pression ayant un niveau qui permet à la résine et aux fibres dudit composant de moulage en feuille de s'écouler à l'intérieur desdits premier et deuxième trous d'épingle (14a, 14b), et
- ouvrir ledit moule (10) et retirer ledit empilement durci dudit moule (10).

7. Procédé de la revendication 6,
**caractérisé en ce que** le moule (10) destiné à recevoir l'empilement de couches (2, 4a, 4b, 6, 8) comprend une cavité cubique ayant une première section transversale lorsqu'on la regarde dans la direction des broches conductrices (16a, 16b), et **en ce que** les couches (2, 4a, 4b, 6, 8) contenues dans l'empilement présentent une deuxième section transversale ayant une aire qui couvre entre 80 % et 95 %, de préférence 90 % de l'aire de la première section transversale.

8. Procédé de la revendication 6 ou 7,
**caractérisé en ce que** lesdites première et deuxième couches conductrices (4a, 4b) sont constituées de cuivre, et **en ce que** ledit cuivre est prétraité, en particulier décapé et/ou sablé, avant de placer ledit métal en feuille entre lesdites couches (2, 6 et 8) de composé de moulage en feuille non durci.

9. Procédé selon la revendication 7 ou 8,
**caractérisé en ce que** la couche de base (2) et/ou la couche de revêtement (8) comportent un agent antiadhésif interne qui empêche la couche de base (2) et/ou la couche de revêtement (8) d'adhérer à des parties chauffées du moule (10).
